# EUROPEAN PATENT APPLICATION

(11) **EP 1 388 884 A2**
(43) Date of publication of application: **11.02.2004**
(21) Application number: 03017250.6
(22) Date of filing: 30.07.2003
(51) Int. Cl.: H01J 37/317

(54) **Electron beam proximity exposure apparatus**

(30) Priority: 08.08.2002 US 216070
(71) Applicant: TOKYO SEIMITSU CO.,LTD., Mitaka-shi Tokyo (JP); Leepl Corporation, Hachioji-city, Tokyo (JP)
(72) Inventor: Utsumi, Takao, Leepl Corporation, Hachioji-city, Tokyo (JP); Kawamura, Yukisato, Tokyo Seimitsu Co., Ltd., Hachioji-city, Tokyo (JP)
(74) Representative: COHAUSZ & FLORACK

(57) **Abstract**

A compact and low-cost electron beam proximity exposure apparatus with high throughput has been disclosed. The apparatus comprises vacuum chamber, a mobile stage that is contained in the vacuum chamber and moves while holding plural specimens, and plural electron beam proximity exposure sections that are provided to the vacuum chamber additionally and use beams of electron passing through the openings of masks arranged in close proximity to each surface of the plural specimens to form patterns corresponding to the openings by exposure on the surfaces of the specimens.

## Description

### BACKGROUND OF THE INVENTION

The present invention relates to an electron beam proximity exposure apparatus that irradiates a mask with a beam of electrons to pattern by exposure in a state in which a mask (a mask of equivalent size), that has an opening pattern the same as the pattern to be formed by exposure, is arranged in close proximity to a wafer. More particularly, the present invention relates to a technology that can realize a compact electron beam proximity exposure apparatus with an improved throughput and a low cost.

The degree of integration of a semiconductor integrated circuit is specified by the micro-machining technology and a high performance is required for the micro-machining technology. Particularly, in the exposure technology, a technical limit is expected to be reached for photolithography using a stepper, and it is very difficult to further advance the micro-machining technology. The electron beam exposure technology has attracted interest as a technology that breaks through the limit, but there is a problem that the throughput of the electron beam exposure technology is generally low. United States Patent No. 5831272 (Japanese Patent No. 2951947) has disclosed an electron beam proximity exposure technology with which the exposure can be completed in a brief time by arranging a resist-coated specimen (wafer) in close proximity to a stencil mask that has the same opening pattern as the exposure pattern and by scanning the mask with an electron beam of a large size.

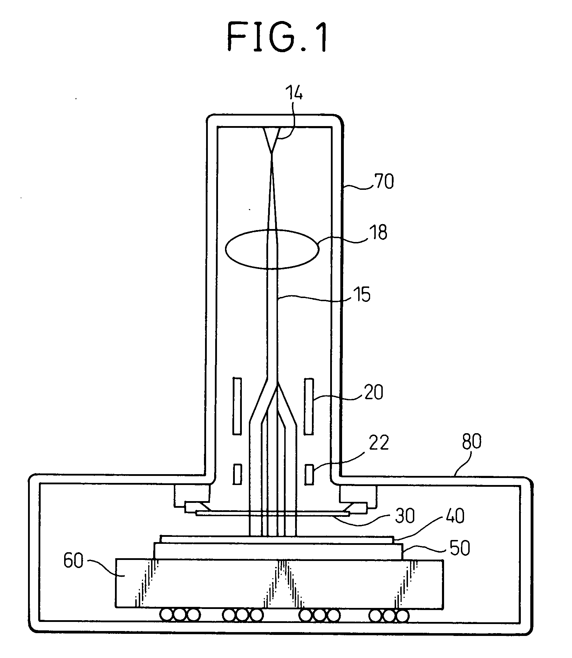

FIG.1 is a diagram that shows the basic structure of the electron beam proximity exposure apparatus disclosed in United States Patent No. 5831272. As shown in FIG.1, in a column 70, an electron source 14 that provides a beam of electrons 15, a condensing lens 18 that forms a beam of electrons into a parallel beam, a main deflecting system 20 and a sub-deflecting system 22 are provided. In a vacuum chamber 80, a mask 30 that has an opening corresponding to the pattern to be formed by exposure and a chuck stage 50 that holds a specimen (semiconductor wafer) 40, on the surface of which a resist layer is formed, with an electrostatic chuck, are provided. The chuck stage 50 can move in the three axial directions and rotate by means of a stage 60. The mask 30 has a thin film on which an opening pattern is formed and the wafer 40 is arranged so that the surface is in close proximity to the mask. If, in this state, the mask is irradiated with a beam of electrons perpendicularly thereto, the beam of electrons passing through the opening of the mask is directed to the resist layer on the surface of the wafer 40.

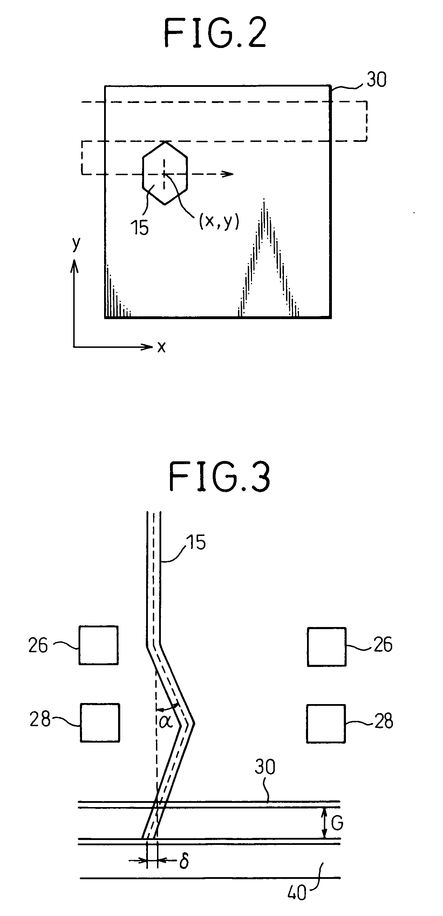

As the size of the beam of electrons 15 is smaller than that of the mask 30, the beam of electrons 15 is deflected by the main deflecting system 20 and the pattern of the entire surface of the mask is formed by exposure on the wafer 40 by scanning the surface of the mask 30 with the beam of electrons 15, as shown in FIG.2. In FIG.1, a beam deflected to three points is shown. After deflecting and displacing the beam of electrons 15 from the optical axis, the main deflecting system 20 deflects the deflected beam of electrons 15 in the opposite direction by the amount identical to that of the previous deflection so that the beam of electrons 15 impinges on the mask 30 perpendicularly. The sub-deflecting system 22 is used to correct the shift in exposure position due to the distortion of the mask and that of the shape of the chip on the wafer and the error of the incident angle of the beam of electrons to the mask due to the deflection by the main deflecting system, which will be described below.

The electron beam proximity exposure apparatus is able to perform the exposure of a pattern, the line width of which is 0.1µm or less, and it is necessary to manufacture the opening pattern portion of the mask 30 so that the thickness is approximately 0.5µm. As the opening pattern differs from position to position, there is part where the ratio of opening is large and part where it is low, resulting in distortion in the opening pattern of the mask 30 depending on position. Although this distortion is not so large, a precision of approximately 0.02µm or less is required for the pattern exposure position in order to form an exposure pattern that has the line width of 0.1µm or less, therefore, the error in the pattern exposure position due to the above-mentioned distortion needs to be corrected. The sub-deflecting system 22 is, therefore, made to have a two-stage structure composed of two deflectors 26 and 28 , and after deflected by the deflector 26 by the angle α, the beam of electrons 15 is deflected by the deflector 28 in the opposite direction by twice the angle ( - 2α) and directed to the same position on the mask 30 with an incident angle -α, as shown in FIG.3. As a result, the beam of electrons passing through the opening of the mask is directed to a position δ away from the irradiation position in the case of the vertical incidence. δ is expressed as δ= -αG, where G is the gap between the mask 30 and wafer 40. In this way, it is possible to slightly change the exposure position of the opening pattern on the wafer 40 by changing the incident angle without the necessity of changing the irradiation position on the mask by the sub-deflecting system. Although the case of a deflection in only one direction is described in FIG.3, there may be a case where the incident angle in the direction perpendicular to the plane of the paper is changed. It is, therefore, necessary for the sub-deflecting system to be able to perform deflection in two directions, that is, in the X direction and the Y direction, independently, and an electrostatic deflector is used.

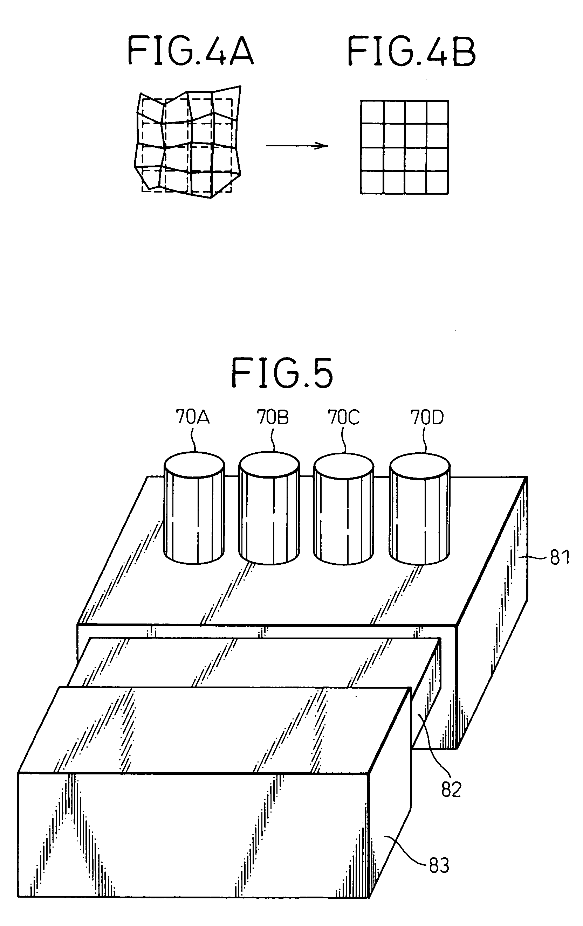

When the mask is distorted as shown in FIG.4A, it is possible to form a normal pattern by exposure without distortion as shown in FIG.4B by shifting the exposure position by changing the incident angle of the beam of electrons partially. The incident position of the beam of electrons changes because it is temporarily deflected by the main deflecting system and then deflected in the opposite direction by the same amount, but it enters the mask perpendicularly. A slight error, however, is actually produced in the incident angle depending on the position of deflection. This error in the incident angle causes an error in the exposure position. The sub-deflecting system is also used to correct this error.

Although the electron beam proximity exposure apparatus can drastically improve throughput compared to the conventional electron beam exposure apparatus, a further improvement in throughput is required. Japanese Patent Application No. 2001-294181 has disclosed an exposure system in which plural electron beam proximity apparatuses are provided in a vacuum chamber and a mask inspecting machine and a mask correcting machine are integrally incorporated therein. In this system, plural exposure sections are provided in a vacuum chamber and each exposure section has an electronic column for proximity exposure and a stage. By means of this system, the throughput of the system can be improved because plural wafers can be exposed in parallel.

There is a problem, however, that the size of the system becomes very large because plural electron beam proximity exposure apparatuses are provided in a vacuum chamber. Moreover, as plural electron beam proximity exposure apparatuses are combined, the cost of the system is about the cost of a single electron beam proximity exposure apparatus multiplied by the number.

### SUMMARY OF THE INVENTION

The objective of the present invention is to realize an electron beam proximity exposure apparatus to meet the demand for a compact electron beam proximity exposure apparatus, which has a high throughput and a low cost.

In order to realize the above-mentioned object, in the electron beam proximity exposure apparatus of the present invention, the stage is made common.

In other words, the electron beam proximity exposure apparatus of the present invention comprises a vacuum chamber, a mobile stage that is contained in the vacuum chamber and can move while holding plural specimens, and plural electron beam proximity exposure sections that are provided in the vacuum chamber additionally and use the beam of electrons passing through the opening of the mask arranged in close proximity to the surface of each specimen to form exposure patterns corresponding to the openings on the surfaces of the specimens.

In the electron beam proximity exposure apparatus, the electron beam proximity exposure section (column) has a simple structure and its cost is low, and the stage that moves while holding a specimen is expensive and requires most of the space, therefore, by making the stage common, as in the electron beam proximity exposure apparatus of the present invention, a reduction in cost and space can be attained.

Each electron beam proximity exposure section is made to have the structure disclosed in United States Patent No. 5831272 as shown in FIG.1. In this case, a wafer is irradiated with a beam of electrons.

It is, however, also possible to design a structure so that the same wafer is irradiated with plural beams of electrons simultaneously in each electron beam proximity exposure section. In this case, different chips (dies) on a wafer are exposed to light simultaneously. Such a structure can be realized by arranging plural columns in close proximity to each another in each electron beam proximity exposure section. In this case, it is possible to provide respective bodies or a common body for plural columns. It is also possible to provide the common main deflecting system and plural sub-deflecting systems, which together make up the deflecting system. Moreover, the mask that is irradiated with plural beams of electrons in each electron beam proximity exposure section can be single or plural.

There are provided plural chuck stages that hold plural specimens on the mobile stage. Since it is necessary to determine the positions of the plural wafers held by the common mobile stage with respect to the corresponding masks, it is desirable to provide the rotation adjusting mechanism and the moving mechanism to the chuck stage. Since the rotation adjusting mechanism and the moving mechanism serve only to correct the errors caused when a wafer is held on the chuck stage, the rotating range of the rotation adjusting mechanism and the moving range of the moving mechanism can be small. In each column, a relative position detector that detects the relative position between the mask and each die of the wafer is provided to align the mask with the position of each die of the wafer by performing an adjustment based on the relative position detected by the rotation adjusting mechanism and the moving mechanism of the chuck stage.

As described above, in the electron beam proximity exposure apparatus, it is possible to adjust the irradiation position, on the wafer, of the beam of electrons passing through the mask by changing the incident angle of the beam of electrons to the mask. By utilizing this function, a shift in position can be adjusted as long as it is slight. After the position is determined, a wafer is put on and held by the chuck stage, and if the shift in position and that in the direction of rotation of the wafer with respect to the mask are small, they can be adjusted only by changing the incident angle of the beam of electrons to the mask, therefore, it is not necessary to provide the rotation adjusting mechanism and the moving mechanism to the chuck stage in this case.

In order to expose plural wafers simultaneously, it is important to supply plural wafers that are not exposed yet to plural chuck stages and recover the plural wafers that are already exposed from the plural chuck stages without lowering the throughput. It is also important to supply and set plural masks to be used for exposure and recover the plural used masks without lowering the throughput.

There are provided, therefore, plural sub-chambers in plural specimen or mask conveying mechanisms that convey specimens or masks to plural chuck stages. When sending or taking out masks or wafers to/from the vacuum chamber, the sub-chamber is brought into a vacuum state. In this way, it is possible to send or take out masks or wafers while keeping the inside of the vacuum chamber in a vacuum state.

In order to efficiently replace wafers to be exposed to light or masks to be used without lowering throughput, two sets of plural specimen or mask conveying mechanisms are further provided. In this way, the time required for replacement can be reduced by preparing wafers or masks to be set next in advance in one of the sets, conveying the exposed wafers or used masks to the other set, and immediately conveying and setting the prepared wafers or masks.

It is also possible to make the plural specimen conveying mechanisms and the plural mask conveying mechanisms shared.

Moreover, it is possible to make at least part of the plural sub-chambers a common sub-chamber.

### BRIEF DESCRIPTION OF THE DRAWINGS

The features and advantages of the invention will be more clearly understood from the following description taken in conjunction with the accompanying drawings, in which:
FIG.1 is a diagram that shows the basic structure of the electron beam exposure of the proximity exposure method.
FIG.2 is a diagram that shows the scanning of the electron beam in the electron beam exposure of the proximity exposure method.
FIG.3 is a diagram that shows the deflecting action of the electron beam by the deflecting system.
FIG.4A and FIG.4B are diagrams that illustrate the correction of distortion of the mask.
FIG.5 is a diagram that shows the external view of the electron beam proximity exposure apparatus in the first embodiment of the present invention.
FIG.6A and FIG.6B are diagrams that show the portion of the stage in the first embodiment.
FIG.7 is a diagram that shows the top view of the electron beam proximity exposure apparatus in the first embodiment.
FIG.8 is a diagram that illustrates the setting space of the stage when four units of the electron beam proximity exposure apparatus that scans a mask with a single beam are arranged.
FIG.9A and FIG.9B are diagrams that show examples of the masks used in the first embodiment.
FIG.10 is a diagram that shows a modification example of the first embodiment.
FIG.11 is a diagram that shows the top view of the electron beam proximity exposure apparatus in the second embodiment of the present invention.
FIG.12A is a diagram that shows the structure of the column of the electron beam proximity exposure apparatus in the second embodiment.
FIG.12B is a diagram that shows the structure of the column of a modification example of the second embodiment.
FIG.13 is a diagram that illustrates the position of the pattern to be formed by exposure on a wafer in the second embodiment.
FIG.14A and FIG.14B are diagrams that illustrate the position of the mask pattern when the intervals of the columns coincide with the arrangement pitch of the die and when they do not coincide with each other in the second embodiment.
FIG.15A and FIG.15B are diagrams that show modification examples of the second embodiment.

### DESCRIPTION OF THE PREFERRED EMBODIMENTS

FIG.5 is a diagram that shows the external view of the electron beam proximity exposure apparatus in the first embodiment. As shown schematically, four columns 70A, 70B, 70C and 70D are provided in a main vacuum chamber 81. A load lock chamber denoted by reference number 82 performs pre-alignment of a mask and a wafer conveyed by a conveying robot 83 with lifting ability, and in the case of the wafer, it comprises a mask/wafer conveying mechanism that sends a wafer into the main vacuum chamber while holding it on a palette. The mask/wafer conveying mechanism takes out the wafer to which exposure is completed and the mask that is not used any more from the main vacuum chamber 81. The load lock chamber 82 has a gate that can be opened and closed freely, cutting off the path between the conveying robot 83 and the main vacuum chamber 81. When receiving a mask or a wafer from the conveying robot 83, the load lock chamber 82 brings its internal portion into the atmosphere state in a state in which the gate is closed so as to be cut off from the main vacuum chamber 81, then opens the gate to make a path to the conveying robot 83 for receiving and delivering. Next, the load lock chamber 82 closes the gate to cut off from the conveying robot 83 and brings its internal portion into a vacuum state and then it opens the gate to make a path to the main vacuum chamber 81 and sends a mask or a wafer into the main vacuum chamber 81. When recovering a mask or a wafer from the main vacuum chamber 81, it acts in reverse.

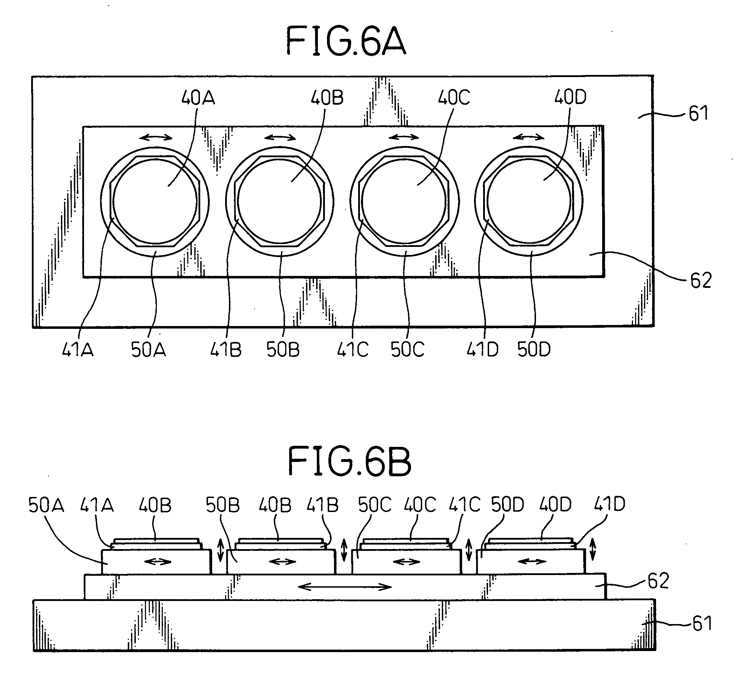

FIG.6A and FIG.6B are diagrams that show stages arranged in the main vacuum chamber 81. A stage 62 can move in the three directions, that is in the X, Y and Z axial directions, by means of a three-dimensional moving mechanism 61. On the stage 62, four chuck stages 50A, 50B, 50C and 50D are provided. The rotating position of each chuck stage can be adjusted within a range of approximately 5 degrees and each can move horizontally within a range of approximately 10 mm. It is, in addition, desirable that the slope of the top surface of each chuck stage can also be adjusted.

Each chuck stage secures and holds with electronic chuck palettes 41A, 41B, 41C and 41D which are conveyed from the load lock chamber 82 and on which wafers 40A, 40B, 40C and 40D are put, respectively. The stage 62 moves so that the wafers 40A, 40B, 40C and 40D are positioned under the columns 70A, 70B, 70C and 70D, respectively, and exposure is performed. In other words, four units of the electron beam proximity exposure apparatus are constructed within the vacuum chamber 81.

In the present embodiment, the masks to be set to each column are also conveyed and set from the conveying robot 83 to the main vacuum chamber 81 via the load lock chamber 82. The masks that are not used any longer are returned into the load lock chamber 82 and conveyed out by the conveying robot 83.

The load lock chamber 82 is a chamber in which four apparatuses are provided to perform pre-alignment of four wafers and masks.

As described above, after undergoing pre-alignment by the load lock chamber 82, the wafers are set on the chuck stages 50A, 50B, 50C and 50D. It is, however, impossible to sufficiently reduce the shifts in position between the masks and wafers only by setting them in this way. The wafers (palettes) are, therefore, set on the chuck stages 50A, 50B, 50C and 50D, the shifts in position between the masks and the wafers are detected by a relative position detector that detects the relative position but is not shown here, and the shifts in position from the masks are corrected respectively using the rotating mechanism and the horizontally moving mechanism of the wafer chuck stage. There are an optical type, an electron beam type, and so on, among the relative position detectors.

Since the rotation adjusting mechanism and the moving mechanism of the chuck stage are used only to correct the errors produced when the wafers are held on the chuck stage, the rotating range of the rotation adjusting mechanism and the moving range of the moving mechanism can be small.

As described above, in the electron beam proximity exposure apparatus, the irradiation position on the wafer by the beam of electrons passing through the mask can be adjusted by changing the incident angle of the beam of electrons to the mask. It is, therefore, also possible to correct the shifts in position between the masks and the wafers using both the rotation adjusting mechanism and the moving mechanism of the chuck stage.

On the other hand, since the plural wafers 40A, 40B, 40C and 40D have undergone the pre-alignment by the load lock chamber 82, if the shifts in position between the masks and the wafers are sufficiently small after they are set on the chuck stages 50A, 50B, 50C and 50D, it is possible to correct the shifts in position only by changing the incident angle of the beam of electrons to the mask, that is, by using only the function to change the irradiation position on the wafer. In this case, it is not necessary to provide the rotation adjusting mechanism and the moving mechanism to the chuck stage.

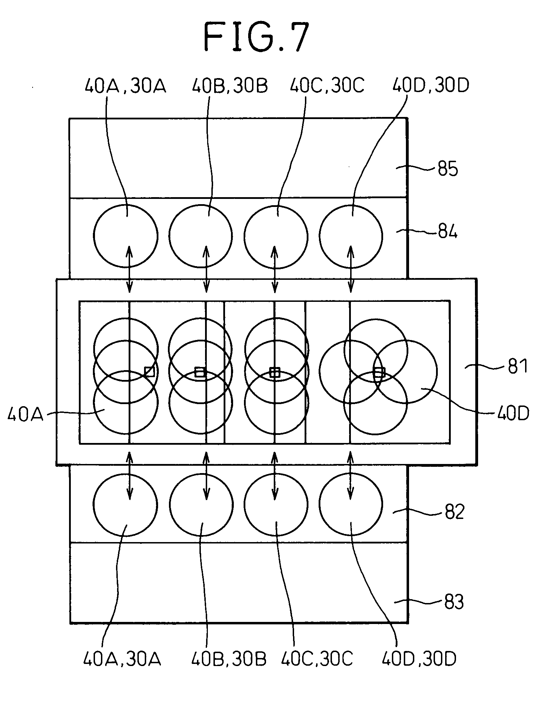

FIG.7 is the top view of the electron beam proximity exposure apparatus in the first embodiment. Although not shown in FIG.5, a load lock chamber 81 and a conveying robot 85 that are the same as those on the front are provided on the back of the main vacuum chamber 81. By means of these, wafers and masks can be taken in/out to/from the back of the main vacuum chamber 81 as in the case of using the front.

If wafers or masks to be set next to one of the load lock chamber 82 on the front side or the load lock chamber 84 on the back, the wafers to which exposure is completed or the masks to be disposed of are conveyed to the other side, and the wafers or the masks prepared in advance are immediately conveyed and set, the time required for replacement can be reduced and the degradation of throughput can be small.

To form a pattern by exposure on the entire surface of a wafer, it is necessary for the exposure range of the wafer (range where dies are formed) to be included within the exposure range of each column. It is, therefore, necessary for the wafer to be able to move in the X direction and in the Y direction a distance of about the diameter of each wafer. In the first embodiment, as four wafers move while being set on the stage 62, the stage 62 is required to be able to move in the X direction and in the Y direction a distance of about the diameter of each wafer.

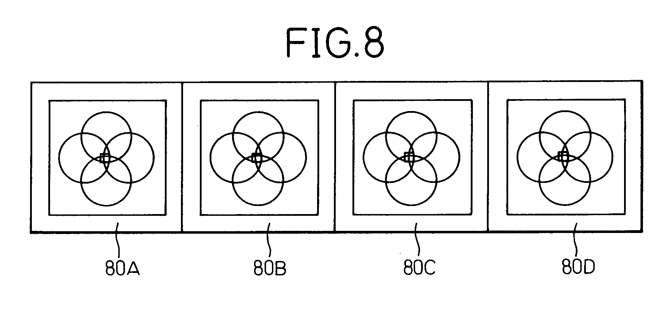

It can be seen that the length of the chamber can shortened in the case of the first embodiment compared to that of the conventional one after reference to FIG.8. FIG.8 shows the case where four electron beam exposure apparatuses 80A, 80B, 80C and 80D, each of which is conventional one and shown in FIG.1, are arranged in line similarly to the case of the first embodiment. It is necessary for the chuck stage of each electron beam exposure apparatus to be able to move both in the X direction and in the Y direction a distance of approximately the diameter of the wafer, therefore, the chuck stage has a size (installation area) corresponding to the moving range. In other words, the lengths of each apparatus in the X direction and in the Y direction are at least equal to or longer than the diameter of the chuck stage plus that of the wafer. For the sake of simplicity, it is assumed here that the diameter of the chuck stage is the same as that of the wafer and the lengths of the other portions are very short. Then, the lengths of each apparatus in the X direction and in the Y direction are equal to or longer than double the diameter of the wafer. As four units of such an apparatus are arranged adjacently, the length of the entire apparatus in the X direction becomes eight times the diameter of the wafer.

Contrary to this case, as the range in which the four chuck stage can move independently can be small in the first embodiment, they can be arranged in close proximity to each another, and the length of the moving platform of the stage 62 in the X direction is four times the wafer. As a result, as the stage 62 is required only to be able to move a distance of the diameter of the wafer, the length of the entire apparatus in the X direction needs to be five times the diameter of the wafer.

In this way, the length of the stage 62 in the X direction in the first embodiment can be shortened compared to the case where the four electron beam exposure apparatuses are arranged in parallel, therefore, the installation space can be reduced. Although the portion of the moving platform becomes longer, the cost can be reduced compared to the case where four stages are used because only one stage, which has the moving range of the same as that of the stage of an electron beam exposure apparatus, is required.

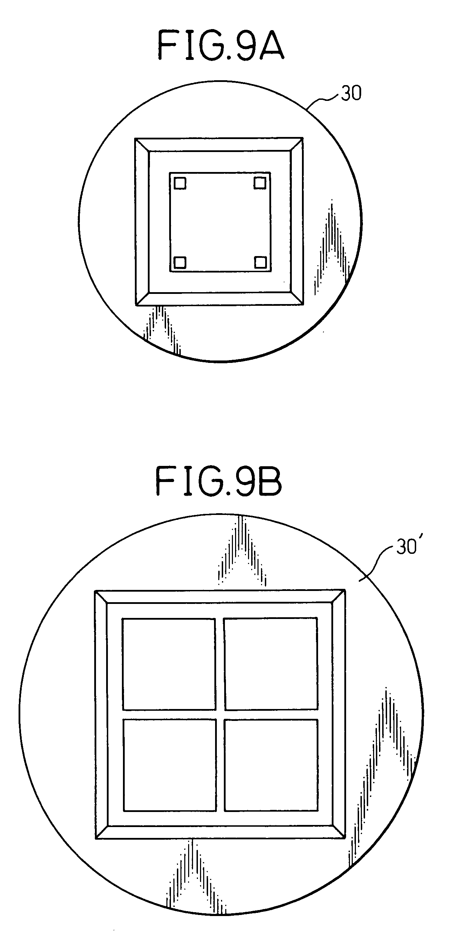

Next, the mask is described briefly. A mask for an electron beam proximity exposure can be manufactured, for example, in the method disclosed in US2002/0070354A1. A mask is set in each column. Although it is possible to use the mask 30 that has a pattern corresponding to a die or part of a die as shown in FIG.9A, it is also possible to use a mask 30' that has a pattern corresponding to plural dies as shown in FIG.9B.

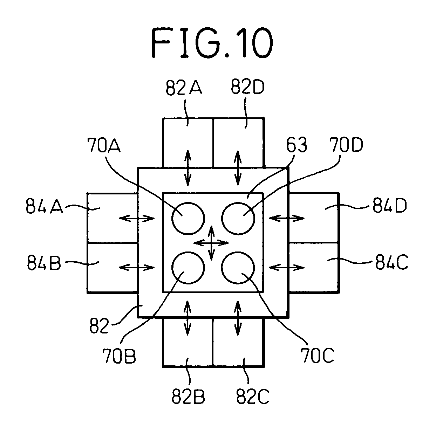

There are various modification examples for the method of arranging plural columns. FIG.10 shows an example case where four columns are arranged in a 2x2 matrix, wherein a stage 63 has a top surface that is almost square. In this case, load lock chambers 82A and 84A for taking in/out wafers and masks to/from the column 70A are provided on the upper base line and the left side line, respectively, in the figure, load lock chambers 82B and 84B for taking in/out wafers and masks to/from the column 70B are provided on the lower base line and the left side line, respectively, in the figure, load lock chambers 82C and 84C for taking in/out wafers and masks to/from the column 70C are provided on the lower base line and the right side line, respectively, in the figure, and load lock chambers 82D and 84D for taking in/out wafers and masks to/from the column 70D are provided on the upper base line and the right side line, respectively, in the figure.

Although the load lock chamber of wafers and masks is made common in the first embodiment and in the modification example shown in FIG.1, it is also possible to use the load lock chamber 82 for wafers and the load lock chamber 84 for masks, shown in FIG.7 and in FIG.10, by separating the conveying mechanism of wafers from that of masks.

Moreover, there can be various modification examples according to the number of columns to be provided in a main vacuum chamber.

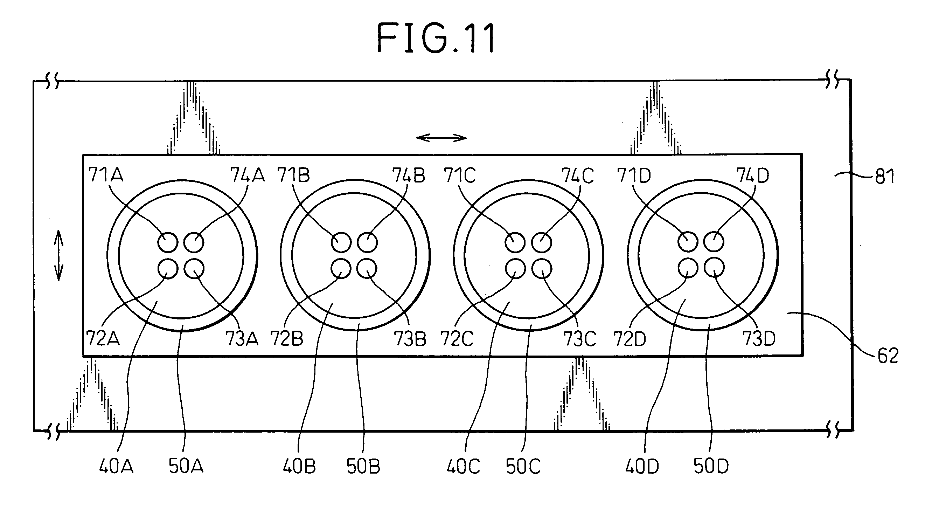

FIG.11 is the top view of the main vacuum chamber 81 of the electron beam proximity exposure apparatus in the second embodiment of the present invention. As shown schematically, the electron beam proximity exposure apparatus in the second embodiment differs from that in the first embodiment in that four columns 71A, 72A, 73A and 74A are provided in accordance with the chuck stage 50A, four columns 71B, 72B, 73B and 74B are provided in accordance with the chuck stage 50B, four columns 71C, 72C, 73C and 74C are provided in accordance with the chuck stage 50C, and four columns 71D, 72D, 73D and 74D are provided in accordance with the chuck stage 50D. In other words, it is characterized in that each electron beam proximity exposure section is composed of four columns. As a result, a wafer is irradiated with four beams of electrons simultaneously via a mask.

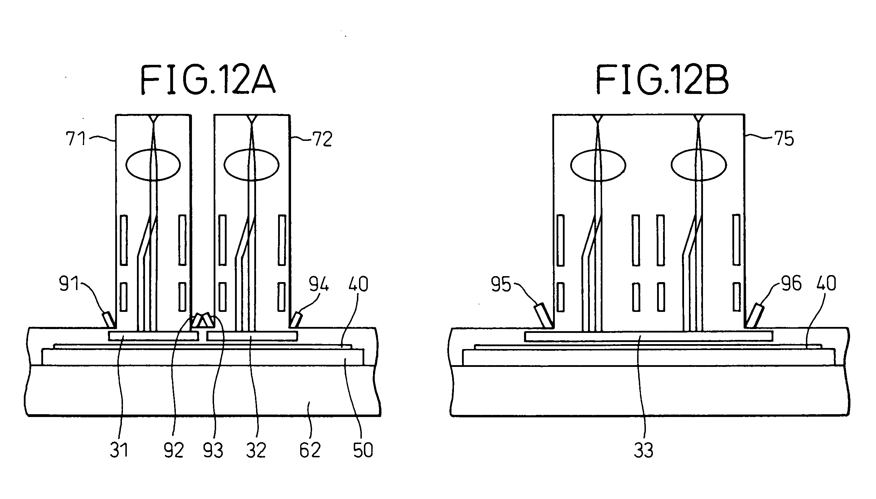

FIG.12A is a sectional view of the portion corresponding to the chuck stage 50 in the second embodiment, wherein only two columns 71 and 72 are shown. The columns 71 and 72 have the same structure as that shown in FIG.1. Masks 31 and 32 are arranged under each column, respectively, and the wafer 40 held by the chuck stage 50 is arranged in close proximity thereunder. Although no palette is used here, it is possible to use a palette as in the first embodiment. Reference numbers 91 and 92 are relative position detectors that detect the shifts in position between the mask 31 and the die on the wafer 40 to be exposed, and reference numbers 93 and 94 are relative position detectors that detect the shifts in position between the mask 32 and the die on the wafer 40 to be exposed. As the shifts in position detected here cannot be corrected by the rotating mechanism and the moving mechanism of the chuck stage 50, they are corrected by adjusting the incident angles of each beam of electrons of the columns 71 and 72 to the masks 31 and 32.

FIG.12B is a diagram that shows a modification example of the second embodiment. In this modification example, a column 75 is provided with, instead of the four columns and four electron sources, four electron lenses that form the electron beams into parallel beams and four main deflecting systems, and four sub-deflecting systems are provided. A mask 33 is arranged in the columns 75 and the mask 33 is irradiated with four beams of electrons. Reference numbers 95 and 96 are relative position detectors that detect the shifts in position between the mask 33 and the die on the wafer 40 to be exposed to light.

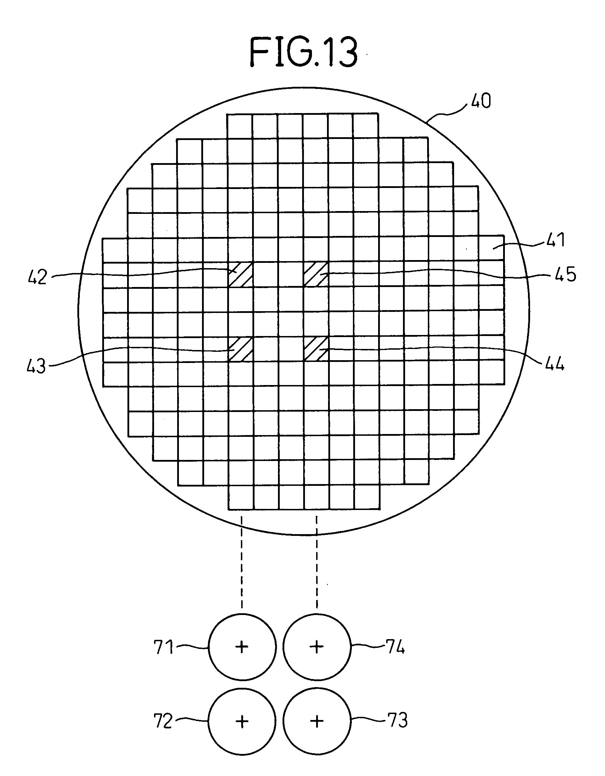

In the second embodiment, the mask is irradiated simultaneously with the four beams of electrons and, therefore, it is necessary to provide the plural main deflecting systems and sub-deflecting systems but the portions between them cannot be irradiated with the beam of electrons. If, therefore, each pattern of the mask is a pattern over the range of a single die, neighboring dies cannot be exposed to light simultaneously and plural discrete dies are exposed to light simultaneously. FIG.13 is a diagram that illustrates this case. As shown schematically, plural dies 41 are arranged on the wafer 40. If it is assumed that the columns 71 to 74 are arranged in a 2x2 matrix and the central axis of each column is separated by a distance of three pitches of each die in the X direction and in the Y direction, dies 42 to 45 in FIG.13 are exposed to light simultaneously, as a result. After three dies neighboring in the X direction (12 dies in total) are exposed to light, the stage 62 moves in the Y direction by a distance corresponding to a die and exposes to light three dies neighboring in the reversal X direction, and it further moves in the Y direction by a distance corresponding to a die and exposes to light three dies neighboring in the original X direction. In this way, 6x6=36 dies are exposed to light. After this, the stage moves in the X direction or in the Y direction by a distance corresponding to four dies and repeats the same actions. When the peripheral portion of the wafer is exposed to light in this case, some of the columns are put into a state in which exposure is not performed. Even if, therefore, four columns are provided, the throughput is not improved by a factor of four, that is, the throughput is not improved in proportion to the number of columns, but a throughput multiplied by a factor of three or more can be attained without problem. In either case, the number of columns and the improvement of the throughput are determined by the arrangement and intervals of columns and the arrangement pitch of dies. As the column of the electron beam proximity exposure apparatus can be realized at a comparably low cost, the effect of the improvement of the throughput is considerable, although the cost performance is degraded, more or less.

A case where neighboring columns are separated by a distance corresponding to three pitches of a die is described here, but in a structure as shown in FIG.12B, the distance between neighboring columns can be reduced, therefore it is possible to arrange neighboring columns so that they are separated by a distance corresponding to two pitches of a die.

When plural discrete dies are exposed simultaneously, as shown in FIG.13, it is required that the interval between patterns to be exposed by neighboring columns be integer multiples of the arrangement pitch of dies. The intervals of the columns, however, are fixed and the arrangement pitch of dies differs depending on the types of the wafer (semiconductor device), therefore, it is unlikely that these conditions are always met. It is, therefore, designed so that the column is made mobile and the interval is made to be adjustable to integer multiples of the pitch of the die.

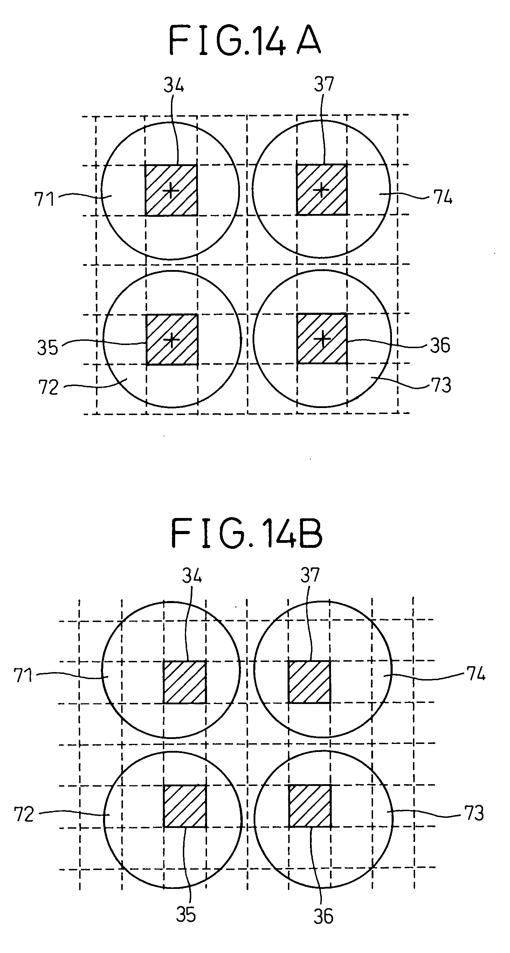

The mechanism that moves the column with precision is very complicated and a problem may occur that costs are increased. The electron beam proximity exposure apparatus has a simple structure as described above, and a comparably wide deflecting range of the beam of electrons can be obtained for the diameter of the column. As shown in FIG.14A, therefore, the neighboring columns 71 to 74 are arranged so that the center of each of the mask patterns 34 to 37 coincides with the central axis of each column when the interval between the columns is an integer multiple of the arrangement pitch of dies. When the interval between the neighboring columns 71 to 74 is not an integer multiple of the arrangement pitch of dies, the columns are arranged so that the interval of the centers of the mask patterns 34 to 37 is an integer multiple of the arrangement pitch of dies. In this case, the centers of the mask patterns 34 to 37 do not coincide with the central axes of the columns, as shown in FIG.14B. It is needless to say that the pattern range of the mask patterns 34 to 37 must be within the deflecting range of the beam of electrons of the columns.

As for the mask(s) used in FIG.14A and FIG.14B, two cases are possible: in one case, four independent masks, each including each of the mask patterns 34 to 37, respectively, are used, and in the other case, only one mask, including the mask patterns 34 to 37, is used.

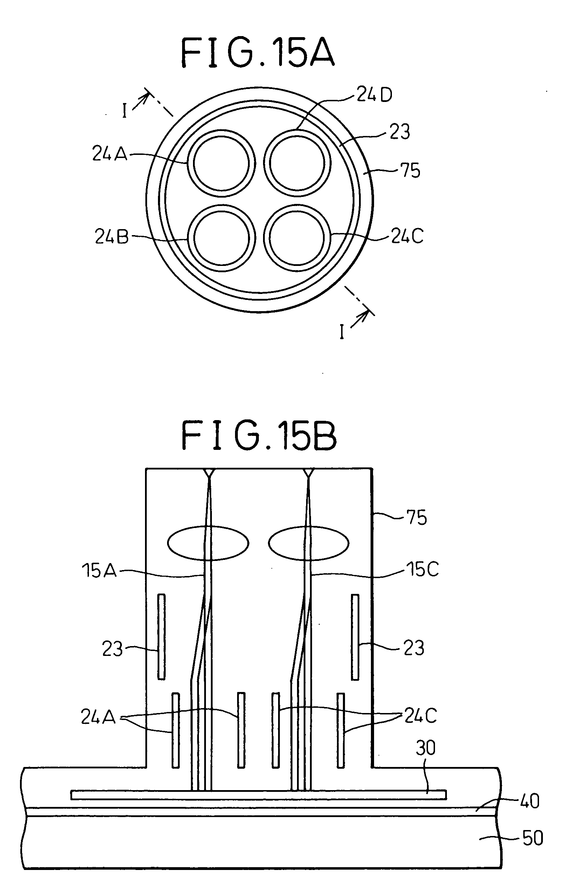

FIG.15A and FIG.15B show other modification examples of the second embodiment. These modification examples have a structure in which the four main deflecting systems are replaced with a main deflecting system 23 in the structure in FIG.12B. As described above, sub-deflecting systems 24A to 24D change the incident angle of the beam of electrons to the mask to change the irradiation position on the wafer of the electron beam passing through the mask, and various adjustments are performed using these systems. It is, therefore, necessary to provide the sub-deflecting systems 24A to 24D individually to each beam of electrons. On the other hand, as the main deflecting system is used to deflect the beam of electrons for scanning and the four beams of electrons are deflected in the same way by the four main deflecting systems during scanning, it is possible to commonly deflect using the main deflecting system 23 alone.

As the number of main deflecting systems can be reduced in the modification example, the cost can be reduced accordingly.

As described above, according to the present invention, a compact electron beam proximity exposure apparatus with a high throughput can be realized at a low cost.

## Claims

1. An electron beam proximity exposure apparatus, comprising: a vacuum chamber; a mobile stage that is contained in the vacuum chamber and moves while holding plural specimens; and plural electron beam proximity exposure sections that are provided to the vacuum chamber additionally and use beams of electrons passing through the openings of masks arranged in close proximity to each surface of the plural specimens to form patterns corresponding to the openings by exposure on the surfaces of the specimens.

2. An electron beam proximity exposure apparatus, as set forth in claim 1, wherein each electron beam proximity exposure section comprises: an electron source that provides the beam of electrons; an electron lens that forms plural beams of electrons into parallel beams; and a deflecting system that can deflect the beam of electrons so as to scan the mask and change the incident angle of the beam of electron to the mask, and it is possible to adjust the irradiation position on the specimen of the beam of electrons passing through the mask by changing the incident angle of the beam of electrons to the mask.

3. An electron beam proximity exposure apparatus, as set forth in claim 2, wherein the deflecting system comprises: a main deflecting system the amount of deflection of which is large; and a sub-deflecting system, the amount of deflection of which is small, and the deflection of the beam of electrons for scanning is carried out by the main deflecting system and the deflection to change the incident angle is carried out by the sub-deflecting system.

4. An electron beam proximity exposure apparatus, as set forth in claim 1, wherein each electron beam proximity exposure section comprises: plural electron sources that provide the beam of electrons; plural electron lenses that form plural beams of electrons into parallel beams; and plural deflecting systems that can defect each beam of electrons so as to scan the mask and change the incident angle of the beam of electrons to the mask, the irradiation position on the specimen of the beam of electrons passing through the mask is adjustable by changing the incident angle of the beam of electrons to the mask, and the same specimen is irradiated with the plural beams of electrons in each electron beam proximity exposure section.

5. An electron beam proximity exposure apparatus, as set forth in claim 4, wherein the deflecting system comprises: a main deflecting system the amount of deflection of which is large; and a sub-deflecting system the amount of deflection of which is small, and the deflection of the beam of electrons for scanning is carried out by the main deflecting system and the deflection to change the incident angle is carried out by the sub-deflecting system.

6. An electron beam proximity exposure apparatus, as set forth in claim 4, wherein plural masks are set in each electron beam proximity exposure section and the plural beams of electrons in each electron beam proximity exposure section scan the corresponding masks.

7. An electron beam proximity exposure apparatus, as set forth in claim 4, wherein a mask is set in each electron beam proximity exposure section and the plural beams of electrons in each electron beam proximity exposure section scan plural portions of the mask.

8. An electron beam proximity exposure apparatus, as set forth in claim 1, wherein each electron beam proximity exposure section comprises: plural electron sources that provide the beam of electrons; plural electron lenses that form plural beams of electrons into parallel beams; a common main deflecting system the amount of deflection of which is large and which deflects the beams of electrons, respectively, so as to scan the mask; and plural sub-deflecting systems the amount of deflection of which is small and which independently deflect the beams of electrons, respectively, so as to change the incident angle of the beam of electrons to the mask, the irradiation position on the specimen of the beam of electrons passing through the mask is adjustable by changing the incident angle of the beam of electron to the mask, and the same mask is irradiated with the plural beams of electrons in each electron beam proximity exposure section.

9. An electron beam proximity exposure apparatus, as set forth in claim 8, wherein plural masks are set in each electron beam proximity exposure section and the plural beams of electrons in each electron beam proximity exposure section scan the corresponding masks.

10. An electron beam proximity exposure apparatus, as set forth in claim 8, wherein a mask is set in each electron beam proximity exposure section and the plural beams of electrons in each electron beam proximity exposure section scan plural portions of the mask.

11. An electron beam proximity exposure apparatus, as set forth in claim 1, wherein the mobile stage comprises: plural chuck stages that chuck the plural specimens; and plural rotation adjusting mechanisms that are provided in accordance with each chuck stage and independently adjust the rotating positions of the plural chuck stages.

12. An electron beam proximity exposure apparatus, as set forth in claim 11, wherein the rotation adjustable range of each rotation adjusting mechanism is within five degrees.

13. An electron beam proximity exposure apparatus, as set forth in claim 11, wherein the mobile stage comprises plural chuck stage moving mechanisms that are provided in accordance with each chuck stage and independently move the plural chuck stages in parallel.

14. An electron beam proximity exposure apparatus, as set forth in claim 13, wherein the movable range of each chuck stage moving mechanism is within 10 mm.

15. An electron beam proximity exposure apparatus, as set forth in claim 1, further comprising: plural sub-chambers that can establish a state of being connected to or a state of being cut off from the vacuum chamber and plural specimen conveying mechanisms that convey the specimen between the sub-chamber and the plural chuck stages.

16. An electron beam proximity exposure apparatus, as set forth in claim 15, wherein two sets of the plural specimen conveying mechanisms are provided.

17. An electron beam proximity exposure apparatus, as set forth in claim 1, further comprising: plural sub-chambers that can establish a state of being connected to or a state of being cut off from the vacuum chamber and plural mask conveying mechanisms that convey the mask between the sub-chamber and the plural electron beam proximity exposure sections.

18. An electron beam proximity exposure apparatus, as set forth in claim 17, wherein two sets of the plural mask conveying mechanisms are provided.

19. An electron beam proximity exposure apparatus, as set forth in claim 15, wherein the plural specimen conveying mechanisms convey the mask between the sub-chamber and the plural electron beam proximity exposure sections.

20. An electron beam proximity exposure apparatus, as set forth in claim 15, wherein the plural chambers are integrated in to a common sub-chamber.

21. An electron beam proximity exposure apparatus, as set forth in claim 17, wherein the plural sub-chambers are integrated into a common sub-chamber.

22. An electron beam proximity exposure apparatus, as set forth in claim 19, wherein at least part of the plural sub-chambers are integrated into a common sub-chamber.

23. An electron beam proximity exposure apparatus, as set forth in claim 1, wherein each electron beam proximity exposure section comprises a relative position detector that detects the relation of relative position between the mask and the specimen.

24. An electron beam proximity exposure apparatus, as set forth in claim 2, wherein each electron beam proximity exposure section comprises a relative position detector that detects the relation of relative position between the mask and the specimen.

25. An electron beam proximity exposure apparatus, as set forth in claim 24, wherein the deflecting system is controlled based on the relation of relative position between the mask and the specimen detected by the relative position detector so that the corresponding position on the specimen is irradiated with the beam of electrons passing through the mask.

26. An electron beam proximity exposure apparatus, as set forth in claim 2, wherein the deflecting system is controlled based on the pattern distortion of the mask measured in advance so that the exposure pattern distortion on the specimen of the beam of electrons passing through the mask is corrected.

27. An electron beam proximity exposure apparatus, as set forth in claim 25, wherein the deflecting system is also controlled based on the pattern distortion of the mask measured in advance so that the exposure pattern distortion on the specimen of the beam of electrons passing through the mask is corrected.

28. An electron beam proximity exposure method using the apparatus as set forth in claim 1, comprising:
holding plural specimens on the mobile stage;
respectively arranging the masks in close to proximity to the surfaces of the plural specimens; and
exposing the plural specimens to the electron beams passing through the openings of the masks to form exposure patterns corresponding to the openings on the surfaces of the specimens.
